(19) Europäisches Patentamt

European Patent Office

Office européen des brevets

(11) **EP 2 045 610 B1**

(12) **FASCICULE DE BREVET EUROPEEN**

(45) Date de publication et mention de la délivrance du brevet:
**12.08.2015 Bulletin 2015/33**

(21) Numéro de dépôt: **08354063.3**

(22) Date de dépôt: **26.09.2008**

(51) Int Cl.:
***G01R 31/08*** *(2006.01)*     ***H02H 7/26*** *(2006.01)*

(54) **Localisation d'un défaut dans un réseau de distribution publique moyenne tension**

Fehlerlokalisierung in einem öffentlichen Mittelspannungsverteilernetz

Location of a fault in a medium-voltage public distribution system

(84) Etats contractants désignés:
**AT BE BG CH CY CZ DE DK EE ES FI FR GB GR HR HU IE IS IT LI LT LU LV MC MT NL NO PL PT RO SE SI SK TR**

(30) Priorité: **05.10.2007 FR 0706990**

(43) Date de publication de la demande:
**08.04.2009 Bulletin 2009/15**

(73) Titulaire: **Schneider Electric Industries SAS 92500 Rueil-Malmaison (FR)**

(72) Inventeur: **Penkov, Delcho 38050 Grenoble Cedex 09 (FR)**

(74) Mandataire: **Péru, Laurence et al Schneider Electric Industries SAS Service Propriété Industrielle WTC / E1 5 Place Robert Schuman 38050 Grenoble Cédex 09 (FR)**

(56) Documents cités:

| | |
|---|---|
| EP-A- 0 106 790 | EP-A- 1 724 597 |
| WO-A-00/50908 | WO-A-98/29752 |
| WO-A-2007/032697 | WO-A-2007/079990 |
| WO-A-2007/090484 | CH-A- 496 241 |
| DE-A1- 4 439 499 | DE-A1- 10 163 405 |
| DE-A1- 10 163 408 | FR-A- 2 803 042 |
| US-A- 5 661 664 | US-A- 5 773 980 |
| US-A1- 2003 155 929 | US-A1- 2007 156 358 |
| US-B1- 6 584 417 | |

EP 2 045 610 B1

**Description**

**DOMAINE TECHNIQUE**

L'invention concerne la localisation d'un défaut, en particulier monophasé, apparu dans un réseau de distribution, et notamment un réseau de distribution publique moyenne tension, le réseau pouvant être mis à la terre par impédance.

Le procédé et le dispositif de localisation selon l'invention utilisent les mesures du courant et de la tension circulant avant et pendant le défaut pour déterminer une distance séparant le défaut du point de mesure. Les hypothèses de calcul sont telles que le résultat obtenu est fiable quelle que soit la nature du défaut et la valeur de sa résistance.

**ETAT DE LA TECHNIQUE**

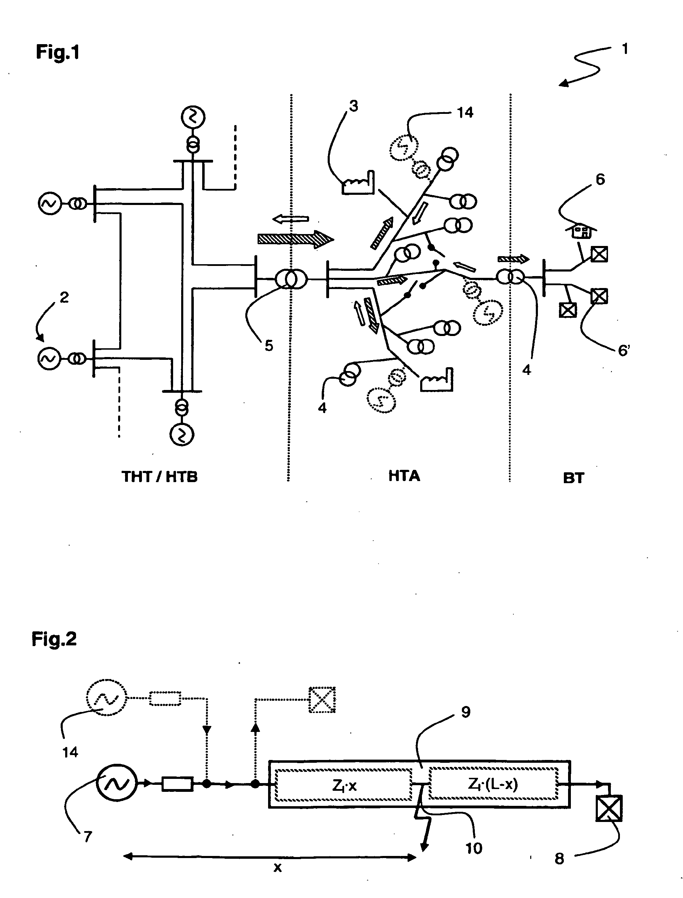

Tel qu'illustré en figure 1, les réseaux 1 de distribution (voir les flèches grisées) peuvent être décomposés en différents niveaux, avec un premier réseau de transport et de répartition très haute et haute tensions THT/HTB (de 35 à plus de 200 kV), utilisé pour transporter ou répartir l'énergie électrique depuis les centrales de production 2 sur de grandes distances. Un réseau de distribution moyenne tension HTA, usuellement entre 1 et 35 kV, et plus précisément 15 ou 20 kV en France, lui succède pour des transports à plus petite échelle, vers des clients de type industriels 3 ou d'autres postes de transformation 4 ; la mise à la terre du réseau HTA, c'est-à-dire la connexion du neutre du transformateur 5, peut être très variée, et est désormais généralement réalisée par une impédance $Z_n$. Le réseau basse tension BT (en particulier 0,4 kV en France) alimente les clients 6, 6' de faible demande énergétique.

Le réseau HTA peut être composé de lignes aériennes et/ou de câbles souterrains. Quelle que soit la solution, le réseau est sujet à des défauts variés, qu'il est important de détecter et localiser afin de pallier les problèmes générés : rupture d'alimentation, dégradation de la tenue des matériels d'isolation, sans compter la sécurité des personnes. Parmi ces défauts, les plus fréquents sont les défauts monophasés, dans lesquels une phase est en contact avec la terre, localisés hors du poste source ; en moyenne, par an, une dizaine de ce type de défauts pour 100 km de ligne persiste malgré une mise hors tension du réseau concerné : ces défauts permanents notamment nécessitent une intervention humaine, et donc une localisation dans le réseau.

De nombreuses études se sont penchées sur la localisation des défauts dans les réseaux de distribution (voir par exemple US 5 839 093), ou plus généralement entre un poste source 7 et une charge 8, sur la ligne 9 d'impédance linéique $Z_1$; en général, une distance x du défaut 10 par rapport au poste source 7 est déterminée, tel qu'illustré en figure 2.

Bien que des méthodes de type heuristiques (réseau de neurones ou logique floue, nécessitant un apprentissage complexe) soient en développement, les déterminations de la distance de défaut x se font usuellement par calculs. Par exemple, les signaux transitoires à haute fréquence qui prennent place immédiatement après l'apparition du défaut sont mesurés, ce qui nécessite cependant des appareils de mesure onéreux, ou les courbes en régime de défaut sont comparées. Ces options imposent une très bonne connaissance du réseau et de sa topologie, ce qui n'est pas toujours possible, ni même réaliste.

De fait, la détermination la plus fréquente utilise un calcul d'impédance, la distance de défaut x étant la solution d'un système d'équations. Certaines méthodes de résolution (par exemple décrites dans WO 00/50908) comprennent des mesures de chaque côté 7, 8 de la ligne, avec la lourdeur inhérente à la communication des données. Les méthodes de localisation en un point de mesure doivent, quant à elles, compenser le fait de ne pas connaître les courants circulant dans les différentes parties du circuit, et des modélisations variées pour résoudre le système d'équations à nombreuses inconnues ont été proposées : voir par exemple US 5 661 664 ou US 5 773 980.

Cependant, les procédés actuels ne donnent pas de résultats suffisamment fiables dans certaines circonstances, notamment pour les défauts 10 monophasés très résistifs ($50 < Z_{def} < 300 \ \Omega$) qui sont relativement fréquents dans des réseaux HTA. En effet, lorsque l'impédance $Z_{def}$ de défaut 10, par nature inconnue, augmente, la précision des calculs est dégradée, et une localisation x utilisable nécessite alors la mesure en différents endroits du réseau. De fait, cette imprécision des méthodes actuelles dépend également de la charge $Z_{ch}$ alimentée à l'apparition du défaut : plus celle-ci est élevée, plus l'impact de la valeur de la résistance du défaut est important. Le document WO 98/29752 prend en compte ce facteur.

Les documents US 2003/155929 A1, EP 0 106 790 A, WO 98/29752 A et WO 2007/090484 A divulguent un procédé et un système de localisation d'un défaut dans un réseau représenté par une ligne électrique d'impédance linéique prédéterminée entre une première extrémité et une charge, comprenant:

a) la mesure du courant et de la tension du réseau à la première extrémité avant l'apparition du défaut;

b) la détermination de l'impédance de la charge par le rapport entre les valeurs complexes des courant et tension mesurés avant défaut;

c) la mesure du courant et de la tension à la première extrémité en situation de défaut;

d) la détermination du courant circulant dans la charge en situation de défaut, en considérant l'impédance de la charge inchangée; et

e) la détermination de la distance de défaut par rapport à la première extrémité par l'intermédiaire des valeurs mesurées, à la première extrémité, du courant et de la tension et de la valeur déterminée du courant circulant dans la charge pendant le défaut.

## EXPOSE DE L'INVENTION

Parmi autres avantages, l'invention vise à pallier des inconvénients des méthodes de calcul de la distance de défaut existantes, notamment dans le cas d'un défaut monophasé avec une résistance à la terre élevée. En particulier, l'invention prend en compte la valeur de la charge alimentée, et, en utilisant les mesures avant défaut, introduit les impédances directe et inverse de la charge dans une modélisation en composantes symétriques du réseau en défaut. La précision du calcul de la distance de défaut est améliorée, et notamment l'erreur sur la distance de défaut, ramenée à la distance maximale dans un réseau HTA donné, est inférieure à 5 %.

Sous un aspect, l'invention concerne un procédé de localisation d'un défaut dans un réseau, en particulier un réseau de distribution moyenne tension triphasé, comprenant toutes les caractéristiques de la revendication 1. En particulier, il comprend la détermination de la distance séparant le défaut d'une première extrémité d'une ligne électrique d'impédance linéique prédéterminée, représentant le réseau. Le procédé selon l'invention utilise la mesure du courant et de la tension à la première extrémité avant l'apparition du défaut et en situation de défaut, et considère la charge du réseau comme non modifiée par l'apparition du défaut, c'est-à-dire que l'impédance de la charge du réseau en défaut est calculée par le rapport entre les valeurs complexes du courant et de la tension mesurées avant le défaut ; ces valeurs complexes peuvent être déterminées par la mesure des courants de chacune des trois phases et des tensions entre chaque phase et la terre.

La connaissance de l'impédance de charge et les mesures des paramètres du courant pendant le défaut (c'est-à-dire avant le déclenchement des appareillages de sécurité) permettent l'établissement d'un système d'équations pour la distance de défaut, et ce par l'intermédiaire d'une modélisation en composantes symétriques du réseau ; le système d'équations est obtenu en considérant dans un premier temps que l'impédance de la ligne est négligeable par rapport à l'impédance de charge en situation de défaut, la charge de départ comme équilibrée et le défaut comme résistif. Le système est de préférence résolu par itérations successives, avec par exemple une initialisation avec une distance de défaut nulle, c'est-à-dire un défaut apparaissant à la première extrémité de la ligne.

En particulier, le système d'équations permettant la détermination de la distance x de défaut est le suivant :

$$x = \frac{\Im(Z)}{X_1} \; ; \; Z = \frac{V_{phase} - Z_1 d \cdot x \cdot (I_{ch}d + I_{ch}i)}{I_{def}},$$

avec $X_1$ réactance de ligne par unité de longueur (c'est-à-dire partie imaginaire de la somme des composantes symétriques de l'impédance linéique de ligne), $Z_1 d$ composante directe de l'impédance linéique de ligne, $V_{phase}$ somme des composantes symétriques des tensions mesurées pendant le défaut, $I_{ch}d$ et $I_{ch}i$ respectivement composantes directe et inverse du courant traversant la charge pendant le défaut, et $I_{def}$ courant de défaut égal à la différence entre les composantes directes des courants mesurés $I_m$ et de charge $I_{ch}$.

L'invention se rapporte également à un dispositif comme décrit dans la revendication 6, apte à mettre en oeuvre le procédé selon l'invention. Le dispositif comprend en particulier des moyens de mesure du courant et de la tension sur une ligne électrique de départ d'un réseau, de préférence pour chacune des phases ; avantageusement, les mesures avant apparition de défaut notamment peuvent être stockées. Le dispositif comprend en outre des moyens pour calculer une impédance de charge du réseau en fonction des mesures du courant et de la tension avant défaut, des moyens pour déterminer le courant de charge pendant le défaut en fonction de l'impédance de charge calculée et des mesures du courant et de la tension pendant le défaut, et des moyens, de préférence par itérations successives, permettant de calculer la distance séparant le défaut du point de mesure des courant et tension en fonction du courant de charge déterminé et du courant et de la tension mesurés pendant le défaut.

Le dispositif selon l'invention comprend des moyens pour déterminer les composantes complexes des valeurs mesurées, et les différents moyens de détermination sont adaptés pour des calculs effectués par l'intermédiaire des composantes symétriques d'une modélisation du réseau.

**BREVE DESCRIPTION DES FIGURES**

D'autres avantages et caractéristiques ressortiront plus clairement de la description qui suit de modes particuliers de réalisation de l'invention, donnés à titre illustratif et nullement limitatifs, représentés dans les figures annexées.

La figure 1, déjà décrite, illustre un réseau de distribution électrique.

La figure 2 schématise l'apparition d'un défaut dans un réseau HTA.

Les figures 3A et 3B illustrent schématiquement le modèle utilisé pour le calcul de la distance de défaut.

**DESCRIPTION DETAILLEE D'UN MODE DE REALISATION PREFERE**

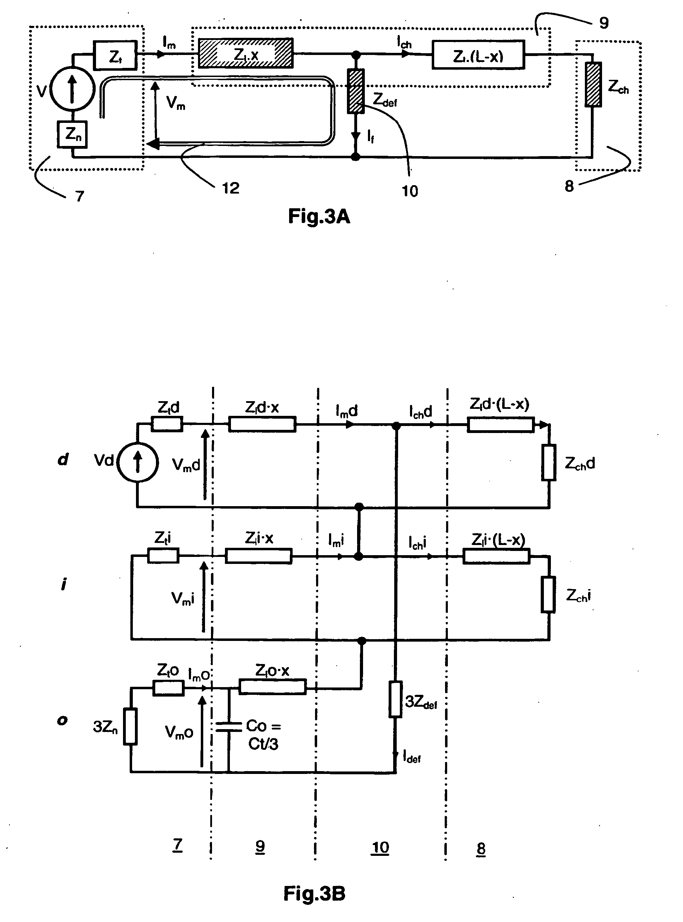

Tel que schématisé en figure 3A, la détermination de la distance de défaut x repose sur le calcul d'une impédance « vue » au niveau d'un point de mesure, en général situé au poste source 7, modélisée par l'impédance $Z_1$-x de la partie de la ligne 9 entre la source 7 et le défaut 10. La partie imaginaire de l'impédance linéique $Z_1$ de la ligne 9 est généralement supposée linéaire, de sorte que la valeur obtenue est proportionnelle à la distance x de défaut. Il est possible à cet égard de décomposer l'impédance de la ligne 9 en fonction de la nature du réseau : si le réseau HTA comprend un pourcentage n de câbles souterrains d'impédance linéique $Z_{1C}$ et le reste de ligne aérienne d'impédance $Z_{1L}$, l'impédance résultante de la ligne 9 peut être considérée comme égale à

$$Z_1 = \frac{1}{100} \cdot \left[ n \cdot Z_{1C} + (100 - n) \cdot Z_{1L} \right].$$

La source 7 est représentée, tel qu'usuel, comme un générateur parfait de tension V associé à une impédance de court-circuit $Z_t$, correspondant à l'impédance du réseau THT/HTB amont et du transformateur HTB/HTA 5. Il est possible de déterminer, à tout instant et notamment avant le défaut, par des moyens usuels, les paramètres complexes $V_m$, $I_m$ (tension et intensité) du courant circulant après le transformateur 5, et notamment des moyens classiques mesurent les trois tensions de phase $V_{m\,1,2,3}$, et les trois courants de phase $I_{m\,1,2,3}$, au niveau du point de mesure 7, ici la première extrémité de la ligne 9, ou source du réseau.

Le réseau HTA présente une charge totale qui est répartie sans qu'il soit possible de connaître précisément l'état de charge d'un réseau, c'est-à-dire que les différentes valeurs affectées aux utilisateurs 3, 4 et la répartition des charges afférentes ne sont pas connues individuellement. Il est classique de représenter le réseau par une charge de départ concentrée en bout de ligne, distante de la longueur L de ligne 9 du poste source 7. En supposant que le réseau est équilibré, la valeur de l'impédance de charge 8 avant défaut peut être déterminée directement :

$$(1) \qquad Z_{ch} = \frac{V_{m\ avant\_defaut}}{I_{avant\_defaut}} - Z_1 \cdot L,$$

avec $V_{m\ avant\_défaut}$ valeur complexe de la tension phase-terre et $I_{m\ avant\_défaut}$ mesure complexe du courant de ligne pris en paire sur n'importe laquelle des trois phases, $Z_1$ impédance par unité de mesure des conducteurs 9 et L distance entre le point de mesure 7 et la charge 8.

L'invention utilise la théorie des composantes symétriques pour le calcul de la distance x : le réseau triphasé déséquilibré suite à l'apparition du défaut 10 monophasé, qui est illustré en figure 3A, est ramené à un schéma tel que présenté en figure 3B, comprenant trois systèmes équilibrés, avec une composante directe d, une composante inverse i et une composante homopolaire $o$ où se retrouve notamment l'impédance de mise à la terre du neutre $Z_n$. En particulier, la charge 8 est décomposée en $Z_{ch}i$ et $Z_{ch}d$ ; sa composante homopolaire est considérée comme de valeur infinie car les charges dans un réseau HTA ne sont pas connectées à la terre et, de fait, le réseau ne comprend pas de composante homopolaire de charge.

L'exemple illustré concerne le cas le plus fréquent, et le plus problématique au niveau fiabilité et précision par les méthodes actuelles, du défaut monophasé 10, symbolisé par une impédance de défaut $Z_{def}$ mettant une phase en contact à la terre, et dont la valeur est inconnue ; les autres situations peuvent naturellement être représentées de la même façon par l'homme du métier.

Pour la localisation, on considère alors la boucle de courant 12, aussi appelée boucle de défaut à 50 Hz et schématisée en figure 3A, que fait le courant de défaut total $I_f$ et qui dépend directement de la distance de défaut x. Par la modélisation en composantes symétriques, l'impédance équivalente $Z_B$ de la boucle 12 répond à l'équation suivante :

$$(2) \qquad Z_B = 3 \cdot Z_{def} + (Z_l d + Z_l i + Z_l o) \cdot x = \frac{V_{phase} - Z_l d \cdot x \cdot (I_{ch} d + I_{ch} i)}{I_{def}},$$

avec $V_{phase} = V_m d_{en\_defaut} + V_m i_{en\_defaut} + V_m o_{en\_defaul}$ valeur de la tension phase-terre de la phase détectée en défaut, les valeurs $V_{m\ en\_défaut}$ étant calculées en utilisant les mesures réalisées sur chaque phase en régime de défaut permanent (entre l'apparition du défaut 10 et le déclenchement des appareillages de sécurité). Classiquement, on considère le défaut 10 comme étant de nature résistive.

Le courant de défaut $I_{def}$, tel qu'illustré en figure 3B, peut être déduit des valeurs des composantes directes du courant mesuré $I_m$ au niveau du poste source 7 et du courant $I_{ch}$ circulant dans la charge 8 pendant le défaut :

$$(3) \qquad I_{def} = I_m d - I_{ch} d$$

Le problème pratique est que, bien que choisie répartie uniquement en bout de ligne 8, la charge exacte du départ $Z_{ch}$ pendant le défaut n'est pas connue ; en outre, tel que mentionné, un état de charge du réseau de distribution n'est pas disponible, par manque de mesures réparties dans le réseau qui permettraient de l'établir. Ainsi les courants de charge direct $I_{ch}d$ et inverse $I_{ch}i$ en régime de défaut ne sont pas connus avec précision.

Il a été vérifié que l'hypothèse d'une charge équilibrée, avec une impédance directe égale à l'impédance inverse, est réaliste ; de plus, au vu des fonctionnalités d'un réseau HTA, il est concevable de négliger les impédances linéiques $Z_1$ de la ligne 9 en régime sans défaut pour calculer l'impédance de charge $Z_{ch}$. Selon l'invention, l'impédance de charge 8 est en outre supposée de valeur $Z_{ch}$ constante avant et pendant le défaut ; ainsi, les mesures des caractéristiques du courant avant défaut, c'est-à-dire des trois tensions phase-terre $V_{m\ 1,2,3}$ et des trois courants $I_{m\ 1,2,3}$ sont utilisées pour, indirectement et par l'intermédiaire de la composante inverse $Z_t i$ de l'impédance équivalente en amont de la première extrémité 7 $\left( Z_t i = -\dfrac{V_m i_{en\_defaut}}{I_m i_{en\_defaut}} \right)$ et du calcul de l'impédance de charge $Z_{ch}$, calculer respectivement les courants direct et inverse dans la charge pendant le défaut.

Selon l'invention, les hypothèses suivantes ont donc été adoptées :

- le réseau est unifilaire et homogène (composé d'un seul type de conducteur 9, ce type pouvant comprendre des composantes aériennes et souterraines tel que mentionné plus haut), avec une totalité de la charge 8 connectée en bout de ligne, c'est-à-dire toujours en aval du défaut 10 ;
- la charge du départ 8 et la charge de la ligne 9 sont équilibrées, avec une impédance directe égale à l'impédance inverse : $Z_{ch}d = Z_{ch}i$ et $Z_1 d = Z_1 i$ - on rappelle que la charge 8 ne comprend en outre pas de composante mise à la terre $Z_{ch}o = \infty$ ;
- les capacités directes, inverses et homopolaires Co des conducteurs sont négligées ;
- les impédances des conducteurs $Z_1$ sont négligées pour le calcul des courants de charge $I_{ch}$ en régime de défaut :

$$(4) \qquad I_{ch} i = -I_m i_{en\_defaut} \cdot \frac{Z_t i}{Z_{ch} i}$$

et

$$(5) \qquad I_{ch} d = I_m d_{en\_defaut} - I_m i_{en\_defaut} + I_{ch} i$$

On note par contre qu'aucune hypothèse n'a été faite en ce qui concerne la valeur de la résistance de défaut $Z_{def}$ ou le courant de défaut $I_f$ qui la traverse : le procédé et le dispositif de détermination selon l'invention s'appliquent ainsi indépendamment de cette valeur, et en particulier continuent à donner des résultats fiables lorsque l'impédance $Z_{def}$ est élevée, y compris lorsqu'elle approche son maximum statistique de 300 Ω.

On obtient donc un système :

$$(6) \qquad x = \frac{\Im(Z_B)}{X_l} \ ;$$

$$(2) \qquad Z_B = \frac{V_{phase} - Z_l d \cdot x \cdot (I_{ch}d + I_{ch}i)}{I_{def}} \ ;$$

les valeurs $I_{ch}i$, $I_{ch}d$, $I_{def}$ étant données par les équations respectives (4), (5) et (3) ; avec $\Im(Z_B)$ partie imaginaire de l'impédance de la boucle 12, et $X_1$ réactance de ligne par unité de longueur (en général le kilomètre), correspondant à

$X_1 = \Im(2 \cdot Z_1 d + Z_1 o) = \Im(Z_1 d + Z_1 i + Z_1 o)$.

Pour résoudre ce système d'équations, on procède de préférence par itérations, avec par exemple une initialisation par une distance de défaut nulle ($x_0 = 0$). Le calcul de la distance de défaut x est considéré comme accompli lorsque la différence entre deux valeurs successives $x_j$, $x_{j+1}$ est inférieure à une précision donnée.

L'invention trouve une application particulière pour les réseaux de distribution moyenne tension de nature aérienne, ou avec peu de câbles souterrains, composant la majorité du réseau français ; cependant, elle ne s'y limite pas. En particulier, bien que l'invention ait été décrite en référence à un défaut monophasé dans lequel elle présente des améliorations notables par rapport à l'état de la technique, la modélisation précédente et les hypothèses faites peuvent tout autant être appliquées pour le calcul de la distance de défaut biphasé, isolé ou à la terre, ou de défaut triphasé : dans ces cas, des simplifications apparaissent dans les équations précédentes, avec notamment la disparition des composantes homopolaires ou inverses.

De même, le calcul proposé a été validé avec des charges « réalistes » 8 et pour les différents types de neutre. En particulier, pour les réseaux HTA du type « à neutre impédant », différentes valeurs de l'impédance du neutre $Z_n$ ont été étudiées, avec un courant de défaut $I_f \geq 50$ A pour une résistance de défaut nulle : mise à la terre directe, purement résistive ou comprenant une partie impédante, notamment $Z_n = 0$, $Z_n = 40j$, $Z_n = 12 + 12j$, $Z_n = 40 \, \Omega$, $Z_n = 80 \, \Omega$,... (avec $j^2 = -1$).

Pour tous les signaux de défauts, le même traitement des données peut ainsi être effectué, et il est possible de réaliser le calcul de la distance de défaut x dès les premières 100 ms qui suivent son apparition. Cet intervalle est généralement suffisant pour l'établissement d'un régime permanent en défaut, tout en restant inférieur à la durée minimale usuelle précédant l'actionnement des organes de protection. La localisation selon l'invention peut donc être réalisée sur les réseaux HTA existants avec fiabilité et précision.

Par ailleurs, la méthode selon l'invention peut être appliquée dans le cas où des générateurs d'énergie dispersés 14 (GED), c'est-à-dire des sources d'énergie de faible puissance nominale comme des éoliennes ou des groupes synchrones, sont mis en place sur le réseau moyenne tension, par exemple tel qu'illustré en figure 1. Bien que ces GED 14 puissent, dans certaines conditions de fonctionnement, perturber le réseau des points de vue plan de tension et harmoniques en introduisant de l'énergie en sens inverse (voir les flèches creuses), la connaissance de leurs paramètres, par exemple par des mesures réalisées directement sur leurs points de connexion au réseau HTA, peut être intégrée dans les algorithmes de calculs selon l'invention, sans modification des autres données, et permettre une localisation de même précision, voire une précision supérieure.

**Revendications**

1. Procédé de localisation d'un défaut (10) monophasé dans un réseau représenté par une ligne électrique (9) d'impédance linéique prédéterminée ($Z_l$) entre une première extrémité (7) et une charge (8) comprenant :

    a. la mesure du courant et de la tension ($I_{m \, avant\_défaut}$, $V_{m \, avant\_défaut}$) du réseau à la première extrémité (7) avant l'apparition du défaut (10) ;
    b. la détermination, réalisée par l'intermédiaire d'une modélisation en composantes symétriques, c'est-à-dire directe, inverse et homopolaire, du réseau, de l'impédance ($Z_{ch}$) de la charge (8) par le rapport entre les valeurs complexes des courant et tension mesurés avant défaut ($I_{m \, avant\_défaut}$, $V_{m \, avant\_défaut}$) ;
    c. la mesure du courant et de la tension ($I_{m \, en-défaut}$, $V_{m \, en\_défaut}$) à la première extrémité (7) en situation de défaut ;
    d. la détermination, réalisée par l'intermédiaire d'une modélisation en composantes symétriques, c'est-à-dire directe, inverse et homopolaire, du réseau, du courant ($I_{ch}$) circulant dans la charge (8) en situation de défaut, en considérant l'impédance de la charge ($Z_{ch}$) inchangée ;

    e. la détermination de l'impédance inverse équivalente ($Z_l i$) en amont de la première extrémité (7) par

$$Z_t i = -\frac{V_m i_{en\_defaut}}{I_m i_{en\_defaut}},$$

f. la détermination, réalisée par l'intermédiaire d'une modélisation en composantes symétriques, c'est-à-dire directe, inverse et homopolaire, du réseau, de la distance de défaut (x) par rapport à la première extrémité (7) par l'intermédiaire des valeurs mesurées, à la première extrémité (7), du courant et de la tension ($I_{m\ en\_défaut}$, $V_{m\ en\_défaut}$) et de la valeur déterminée du courant circulant dans la charge ($I_{ch}$) pendant le défaut, la distance de défaut (x) étant donnée par le système d'équations :

$$x = \frac{\Im(Z)}{X_l} \text{ et } Z = \frac{V_{phase} - Z_l d \cdot x \cdot (I_{ch}d + I_{ch}i)}{I_{def}}, \text{ avec :}$$

- $X_l$ la réactance de ligne par unité de longueur, et partie imaginaire de la somme des composantes de l'impédance linéique prédéterminée $X_l = \Im(Z_l d + Z_l i + Z_l o)$ ;

- $V_{phase}$ la tension à la terre de la phase détectée en défaut et somme des composantes de la tension mesurée en défaut $V_{phase} = V_m d_{en\_defaut} + V_m i_{en\_defaut} + V_m o_{en\_defaut}$ ;
- $I_{def}$ la valeur du courant de défaut et différence entre les composantes directes du courant mesuré ($I_m$) et du courant de charge ($I_{ch}$) en défaut $I_{def} = I_m d - I_{ch}d$ ;
- Ichi et Ichd les composantes inverse et directe du courant de charge valant respectivement :

$$I_{ch} i = -I_m i_{en\_defaut} \cdot \frac{Z_t i}{Z_{ch}} \text{ et } I_{ch}d = I_m d_{en\_defaut} - I_m i_{en\_defaut} + I_{ch}i \text{ avec } Z_t i \text{ l'impédance inverse}$$

équivalente en amont de la première extrémité (7), $Z_{ch}$ l'impédance de charge (8) du réseau, $I_m i_{en\_defaut}$ la mesure du courant en défaut à la première extrémité (7).

2. Procédé selon la revendication 1 dans lequel la mesure (a.) du courant et de la tension du réseau à la première extrémité (7) avant le défaut comprend la mesure des trois courants de chaque phase ($I_{m\ 1,2,3}$) et la mesure des trois tensions entre chaque phase et la terre ($V_{m\ 1,2,3}$).

3. Procédé selon l'une des revendications 1 ou 2 dans lequel la mesure (c.) du courant et de la tension du réseau à la première extrémité (7) pendant le défaut comprend la mesure des trois courants de chaque phase ($I_{m\ 1,2,3}$) et la mesure des trois tensions entre chaque phase et la terre ($V_{m\ 1,2,3}$).

4. Procédé selon l'une des revendications 1 à 6 dans lequel la détermination de la distance de défaut (x) est effectuée par itérations successives pour résoudre un système d'équations.

5. Procédé selon l'une des revendications 1 à 7 dans lequel le réseau est un réseau de distribution moyenne tension et le défaut (10) est monophasé et résistif.

6. Système de localisation d'un défaut dans un réseau de distribution par rapport à un point de mesure (7), le réseau étant assimilé à une ligne électrique (9) d'impédance linéique prédéterminée ($Z_l$) entre le point de mesure (7) d'impédance amont prédéterminée ($Z_t$) et une charge (8) comprenant :

- des moyens de mesure du courant et de la tension ($I_m$, $V_m$) du réseau au point de mesure (7) avant le défaut et pendant le défaut ;
- des moyens de calcul de l'impédance ($Z_{ch}$) de la charge (8) par le rapport entre les valeurs complexes des courant et tension mesurés ($I_m$, $V_m$) par lesdits moyens de mesure avant le défaut ;
- des moyens de détermination du courant ($I_{ch}$) circulant dans la charge (8) du réseau en situation de défaut, en considérant son impédance ($Z_{ch}$) inchangée ;
- des moyens de détermination de la distance de défaut (x) par rapport au point de mesure (7) par l'intermédiaire des valeurs mesurées, par lesdits moyens de mesure, en défaut du courant et de la tension ($I_{m\ en\_défaut}$, $V_{m\ en\_défaut}$) et de la valeur déterminée du courant circulant dans la charge ($I_{ch}$),
- des moyens pour déterminer les composantes symétriques des paramètres du réseau.

- des moyens pour déterminer l'impédance inverse équivalente ($Z_t i$) en amont de la première extrémité (7) par

$$Z_t i = -\frac{V_m i_{en\_defaut}}{I_m i_{en\_defaut}},$$

- les moyens de détermination de la distance de défaut étant adaptés pour résoudre le système :

$$x = \frac{\Im(Z)}{X_1} \text{ et } Z = \frac{V_{phase} - Z_l d \cdot x \cdot (I_{ch} d + I_{ch} i)}{I_{def}}, \text{ avec :}$$

∘ $X_l$ la réactance de ligne par unité de longueur, et partie imaginaire de la somme des composantes de l'impédance linéique prédéterminée $X_1 = \Im(Z_l d + Z_l i + Z_l o)$ ;

∘ $V_{phase}$ la tension à la terre de la phase détectée en défaut et somme des composantes de la tension mesurée en défaut $V_{phase} = V_m d_{en\_defaut} t + V_m i_{en\_defaut} + V_m o_{en\_defaut}$ ;

∘ $I_{def}$ la valeur du courant de défaut et différence entre les composantes directes du courant mesuré ($I_m$) et du courant de charge ($I_{ch}$) en défaut $I_{def} = I_m d - I_{ch} d$ ;

∘ $I_{ch} i$ et $I_{ch} d$ respectivement les composantes inverse et directe du courant de charge ($I_{ch}$), données par:

$$I_{ch} i = -I_m i_{en\_defaut} \cdot \frac{Z_t i}{Z_{ch}} \text{ et } I_{ch} d = I_m d_{en\_defaut} - I_m i_{en\_défaut} + I_{ch} i, \text{ avec } Z_t i \text{ composante inverse de l'im-}$$

pédance équivalente en amont au point de mesure (7), $Z_{ch}$ impédance déterminée de charge (8) du réseau et $I_{m\ en\_défaut}$ mesure du courant en défaut.

7. Dispositif selon la revendication 6 dans lequel les moyens de mesure du courant sont adaptés pour mesurer le courant sur chacune des trois phases du réseau.

8. Dispositif selon la revendication 7 dans lequel les moyens de mesure de la tension sont adaptés pour mesurer la tension à la terre de chacune des trois phases du réseau.

**Patentansprüche**

1. Verfahren zur Lokalisierung eines einphasigen Fehlers (10) in einem Netz, das durch eine elektrische Leitung (9) mit einer vorbestimmten linearen Impedanz ($Z_l$) zwischen einem ersten Ende (7) und einer Last (8) dargestellt ist, umfassend:

a. die Messung des Stroms und der Spannung ($I_{m\ vor\_Fehler}$, $V_{m\ vor\_Fehler}$) des Netzes am ersten Ende (7) vor Auftreten des Fehlers (10);

b. die Bestimmung, die mit Hilfe einer Modellierung des Netzes in symmetrischen Komponenten, d.h. direkt, invers und homopolar, erfolgt, der Impedanz ($Z_{ch}$) der Last (8) durch das Verhältnis zwischen den komplexen Werten von Strom und Spannung, gemessen vordem Fehler ($I_{m\ vor\_Fehler}$, $V_{m\ vor\_Fehler}$);

c. die Messung des Stroms und der Spannung ($I_{m\ bei\_Fehler}$, $V_{m\ bei\_Fehler}$) am ersten Ende (7) in einer Fehlersituation;

d. die Bestimmung, die mit Hilfe einer Modellierung des Netzes in symmetrischen Komponenten, d.h. direkt, invers und homopolar, erfolgt, des Stroms ($I_{ch}$), der in der Last (8) in einer Fehlersituation zirkuliert, unter Berücksichtigung der unveränderten Impedanz der Last ($Z_{ch}$);

e. die Bestimmung der äquivalenten inversen Impedanz ($Z_t i$) stromaufwärts zum ersten Ende (7) durch

$$Z_t i = -\frac{V_m i_{bei\_Fehler}}{I_m i_{bei\_Fehler}},$$

f. die Bestimmung, die mit Hilfe einer Modellierung des Netzes in symmetrischen Komponenten, d.h. direkt, invers und homopolar, erfolgt, der Fehlerdistanz (x) in Bezug zum ersten Ende (7) mit Hilfe der gemessenen Werte am ersten Ende (7) des Stroms und der Spannung ($I_{m\ bei\_Fehler}$, $V_{m\ bei\_Fehler}$) und des bestimmten Wertes des Stroms, der in der Last ($I_{ch}$) während des Fehlers zirkuliert, wobei die Fehlerdistanz (x) durch das folgende Gleichungssystem gegeben ist: $x = \dfrac{\Im(Z)}{X_l}$ und $Z = \dfrac{V_{Phase} - Z_l d * x * (I_{ch}d + I_{ch}i)}{I_{def}}$, wobei:

- $X_l$ die Reaktanz der Leitung pro Längeneinheit und imaginärer Teil der Summe der Komponenten der vorbestimmten linearen Impedanz ist $X_l = \Im(Z_l d + Z_l i + Z_l o)$;
- $V_{Phase}$ die Spannung an der Erde der bei Fehler erfassten Phase und die Summe der Komponenten der bei Fehler gemessenen Spannung ist $V_{Phase} = V_m d_{bei\_Fehler} + V_m i_{bei\_Fehler} + V_m O_{bei\_Fehler}$;
- $I_{def}$ der Wert des Fehlerstroms und die Differenz zwischen den direkten Komponenten des gemessenen Stroms ($I_m$) und des Lastenstroms ($I_{ch}$) bei Fehler ist $I_{def} = I_m d - I_{ch} d$;
- Ichi und Ichd die inverse und direkte Komponente des Lastenstroms sind, die jeweils für: $I_{ch}i = -I_m i_{bei\_Fehler} * \dfrac{Z_l i}{Z_{ch}}$ und $I_{ch}d = I_m d_{bei\_Fehler} - I_m i_{bei\_Fehler} + I_{ch}i$ stehen, wobei $Z_l i$ die äquivalente inverse Impedanz stromaufwärts zum ersten Ende (7) ist, $Z_{ch}$ die Lastenimpedanz (8) des Netzes ist, $I_m i_{bei\_Fehler}$ das Maß für den Strom bei Fehler am ersten Ende (7) ist.

2. Verfahren nach Anspruch 1, bei dem die Messung (a.) des Stroms und der Spannung des Netzes am ersten Ende (7) vor dem Fehler die Messung der drei Ströme jeder Phase ($I_{m\,1,2,3}$) und die Messung der drei Spannungen zwischen jeder Phase und der Erde ($V_{m\,1,2,3}$) umfasst.

3. Verfahren nach einem der Ansprüche 1 oder 2, bei dem die Messung (c.) des Stroms und der Spannung des Netzes am ersten Ende (7) während des Fehlers die Messung der drei Ströme jeder Phase ($I_{m\,1,2,3}$) und die Messung der drei Spannungen zwischen jeder Phase und der Erde ($V_{m\,1,2,3}$) umfasst.

4. Verfahren nach einem der Ansprüche 1 bis 6, bei dem die Bestimmung der Fehlerdistanz (x) durch aufeinanderfolgende Iterationen erfolgt, um ein System von Gleichungen zu lösen.

5. Verfahren nach einem der Ansprüche 1 bis 7, bei dem das Netz ein Netz der durchschnittlichen Spannungsverteilung und der Fehler (10) einphasig und resistiv ist.

6. System zur Lokalisierung eines Fehlers in einem Verteilungsnetz in Bezug zu einem Messpunkt (7), wobei das Netz einer elektrischen Leitung (9) mit einer vorbestimmten linearen Impedanz ($Z_l$) zwischen dem Messpunkt (7) mit einer vorbestimmten stromaufwärtigen Impedanz ($Z_t$) und einer Last (8) gleichgesetzt ist, umfassend:

- Mittel zum Messen des Stroms und der Spannung ($I_m$, $V_m$) des Netzes am Messpunkt (7) vor dem Fehler und während des Fehlers;
- Mittel zur Berechnung der Impedanz ($Z_{ch}$) der Last (8) durch das Verhältnis zwischen den komplexen Werten des gemessenen Stroms und der gemessenen Spannung ($I_m$, $V_m$) durch die Messhilfsmittel vor dem Fehler;
- Mittel zur Bestimmung des Stroms ($I_{ch}$), der in der Last (8) des Netzes in einer Fehlersituation zirkuliert, unter Berücksichtigung seiner unveränderten Impedanz ($Z_{ch}$);
- Mittel zur Bestimmung der Fehlerdistanz (x) in Bezug zum Messpunkt (7) mit Hilfe der durch die Messhilfsmittel gemessenen Werte bei Fehler von Strom und Spannung ($I_{m\,bei\_Fehler}$, $V_{m\,bei\_Fehler}$) und des bestimmten Wertes des in der Last zirkulierenden Stroms ($I_{ch}$),
- Mittel zur Bestimmung der symmetrischen Komponenten der Parameter des Netzes,
- Mittel zur Bestimmung der äquivalenten inversen Impedanz ($Z_t i$) stromaufwärts zum ersten Ende (7) durch

$$Z_t i = -\dfrac{V_m i_{bei\_Fehler}}{I_m i_{bei\_Fehler}},$$

- wobei die Mittel zur Bestimmung der Fehlerdistanz dazu vorgesehen sind, das folgende System zu lösen:

$$x = \dfrac{\Im(Z)}{X_l} \text{ und } Z = \dfrac{V_{Phase} - Z_l d * x * (I_{ch}d + I_{ch}i)}{I_{def}}, \text{ wobei:}$$

◦ $X_l$ die Reaktanz der Leitung pro Längeneinheit und imaginärer Teil der Summe der Komponenten der vorbestimmten linearen Impedanz ist $X_l = \Im(Z_l d + Z_l i + Z_l o)$;

∘ $V_{Phase}$ die Spannung an der Erde der bei Fehler erfassten Phase und die Summe der Komponenten der bei Fehler gemessenen Spannung ist $V_{Phase} = V_m d_{bei\_Fehler} + V_m i_{bei\_Fehler} + V_m o_{bei\_Fehler}$;

∘ $I_{def}$ der Wert des Fehlerstroms und die Differenz zwischen den direkten Komponenten des gemessenen Stroms ($I_m$) und des Lastenstroms ($I_{ch}$) bei Fehler ist $I_{def} = I_m d - I_{ch} d$;

∘ $I_{ch} i$ und $I_{ch} d$ jeweils die inverse und direkte Komponente des Lastenstroms ($I_{ch}$) sind, gegeben durch:

$$I_{ch} i = -I_m i_{bei\_Fehler} * \frac{Z_t i}{Z_{ch}}$$ und $I_{ch} d = I_m d_{bei\_Fehler} - I_m i_{bei\_Fehler} + I_{ch} i$, wobei $Z_t i$ die inverse Komponente der äquivalenten Impedanz stromaufwärts zum ersten Messpunkt (7) ist, $Z_{ch}$ die bestimmte Lastenimpedanz (8) des Netzes ist und $I_{m\,bei\_Fehler}$ das Maß für den Strom bei Fehler ist.

**7.** Vorrichtung nach Anspruch 6, bei der die Mittel zum Messen des Stroms dazu vorgesehen sind, den Strom auf jeder der drei Phasen des Netzes zu messen.

**8.** Vorrichtung nach Anspruch 7, bei der die Mittel zum Messen der Spannung dazu vorgesehen sind, die Spannung an der Erde jeder der drei Phasen des Netzes zu messen.

**Claims**

**1.** Method for locating a single-phase fault (10) in a network represented by an electrical line (9) of predetermined line impedance ($Z_l$) between a first end (7) and a load (8) comprising:

a. the measurement of the current and the voltage ($I_{m\,before\_fault}$, $V_{m\,before\_fault}$) of the network at the first end (7) before the appearance of the fault (10);

b. the determination, made via a modelling in symmetrical components, that is to say forward, reverse and homopolar, of the network, of the impedance ($Z_{ch}$) of the load (8) by the ratio between the complex values of the current and voltage measured before the fault ($I_{m\,before\_fault}$, $V_{m\,before\_fault}$) ;

c. the measurement of the current and the voltage ($I_{m\,fault}$, $V_{m\,fault}$) at the first end (7) in the fault situation;

d. the determination, made via a modelling in symmetrical components, that is to say forward, reverse and homopolar, of the network, of the current ($I_{ch}$) flowing in the load (8) in the fault situation, by considering the impedance of the load ($Z_{ch}$) to be unchanged;

e. the determination of the equivalent reverse impedance ($Z_t i$) upstream of the first end (7) by $Z_t i = -\dfrac{V_m i_{fault}}{I_m i_{fault}}$ ,

f. the determination, made via a modelling in symmetrical components, that is to say forward, reverse and homopolar, of the network, of the fault distance (x) relative to the first end (7) via the measured values, at the first end (7), of the current and of the voltage ($I_{m\,fault}$, $V_{m\,fault}$) and of the determined value of the current flowing in the load ($I_{ch}$) during the fault, the fault distance (x) being given by the system of equations: $X = \dfrac{\Im(Z)}{X_l}$

and $Z = \dfrac{V_{phase} - Z_l d \cdot x \cdot (I_{ch} d + I_{ch} i)}{I_{def}}$ , with:

- $X_l$ being the line reactance per unit of length, and imaginary part of the sum of the components of the predetermined line impedance $X_l = \Im(Z_l d + Z_l i + Z_l o)$;

- $V_{phase}$ being the voltage to earth of the phase detected with a fault and sum of the components of the in-fault measured voltage $V_{phase} = V_m d_{fault} + V_m i_{fault} + V_m o_{fault}$;

- $I_{def}$ being the value of the fault current and difference between the forward components of the measured current ($I_m$) and of the in-fault load current ($I_{ch}$) $I_{def} = I_m d - I_{ch} d$;

- Ichi and Ichd being the reverse and forward components of the load current with the respective values:

$$I_{ch}i = -I_m i_{fault} \cdot \frac{Z_t i}{Z_{ch}}$$ and $I_{ch}d$ $I_m d_{fault}$ - $I_m i_{fault}$ + $I_{ch}i$ with $Z_t i$ being the equivalent reverse impedance upstream of the first end (7), $Z_{ch}$ being the load impedance (8) of the network, $I_m i_{fault}$ being the measurement of the in-fault current at the first end (7).

2. Method according to Claim 1, in which the measurement (a.) of the current and the voltage of the network at the first end (7) before the fault comprises the measurement of the three currents of each phase ($I_{m\,1,2,3}$) and the measurement of the three voltages between each phase and the earth ($V_{m\,1,2,3}$).

3. Method according to one of Claims 1 or 2, in which the measurement (c.) of the current and the voltage of the network at the first end (7) during the fault comprises the measurement of the three currents of each phase ($I_{m\,1,2,3}$) and the measurement of the three voltages between each phase and the earth ($V_{m\,1,2,3}$).

4. Method according to one of Claims 1 to 6, in which the determination of the fault distance (x) is performed by successive iterations to solve a system of equations.

5. Method according to one of Claims 1 to 7, in which the network is a medium-voltage distribution network and the fault (10) is single-phase and resistive.

6. System for locating a fault in a distribution network relative to a measurement point (7), the network being likened to an electrical line (9) of predetermined line impedance ($Z_l$) between the measurement point (7) of predetermined upstream impedance ($Z_l$) and a load (8) comprising:

   - means for measuring the current and the voltage ($I_m$, $V_m$) of the network at the measurement point (7) before the fault and during the fault;
   - means for calculating the impedance ($Z_{ch}$) of the load (8) by the ratio between the complex values of the current and voltage measured ($I_m$, $V_m$) by said measurement means before the fault;
   - means for determining the current ($I_{ch}$) flowing in the load (8) of the network in the fault situation, by considering its impedance ($Z_{ch}$) to be unchanged;
   - means for determining the fault distance (x) relative to the measurement point (7) via the values measured, by said measurement means, in fault, of the current and of the voltage ($I_m$ fault, $V_m$ fault) and of the determined value of the current flowing in the load ($I_{ch}$),
   - means for determining the symmetrical components of the parameters of the network,

   - means for determining the equivalent reverse impedance ($Z_t i$) upstream of the first end (7) by $$Z_t i = -\frac{V_m i_{fault}}{I_m i_{fault}},$$

the means for determining the fault distance being adapted to solve the system: $$x = \frac{\Im(Z)}{X_l}$$ and

$$Z = \frac{V_{phase} - Z_l d \cdot x \cdot (I_{ch}d + I_{ch}i)}{I_{def}}$$ with:

   ◦ $X_l$ being the line reactance per unit of length, and imaginary part of the sum of the components of the predetermined line impedance $$X_l = \Im(Z_l d + Z_l i + Z_l o);$$
   ◦ $V_{phase}$ being the voltage to the earth of the phase detected with a fault and sum of the components of the in-fault measured voltage $V_{phase}$ = $Vmd_{fault}$ + $V_m i_{fault}$ + $V_m o_{fault}$;
   ◦ $I_{def}$ being the value of the fault current and difference between the forward components of the measured current ($I_m$) and of the in-fault load current ($I_{ch}$) $I_{def}$ = $I_m d$ - $I_{ch}d$;
   ◦ $I_{ch}i$ and $I_{ch}d$ being respectively the reverse and forward components of the load current ($I_{ch}$) given by

$$I_{ch}i = -I_m i_{fault} \cdot \frac{Z_t i}{Z_{ch}}$$ and $I_{ch}d = I_m d_{fault}$ - $I_m i_{fault}$ + $I_{ch}i$ with $Z_t i$ being the reverse component of the upstream equivalent impedance at the measurement point (7), $Z_{ch}$ being the determined load impedance (8) of the network and $I_{m\,faul}$t being the measurement of the fault current.

7. Device according to Claim 6, in which the current measurement means are adapted to measure the current on each of the three phases of the network.

8. Device according to Claim 7, in which the voltage measurement means are adapted to measure the voltage to the earth of each of the three phases of the network.

**Fig.1**

THT / HTB          HTA          BT

**Fig.2**

**Fig.3A**

**Fig.3B**

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 5839093 A
- WO 0050908 A
- US 5661664 A
- US 5773980 A
- WO 9829752 A
- US 2003155929 A1
- EP 0106790 A
- WO 2007090484 A